# EUROPEAN PATENT APPLICATION

(11) **EP 4 554 359 A1**
(43) Date of publication of application: **14.05.2025**
(21) Application number: 22951481.5
(22) Date of filing: 20.07.2022
(51) Int. Cl.: H10D 99/00

(54) **PIXEL UNIT AND MANUFACTURING METHOD THEREFOR**

(71) Applicant: Huawei Technologies Co., Ltd., Shenzhen, Guangdong 518129 (CN)
(72) Inventor: ZHANG, Cheng, 97074 Würzburg (DE); KULLOCK, René, 97074 Würzburg (DE); HECHT, Bert, 97074 Würzburg (DE); EWALD, Björn, 97074 Würzburg (DE); RÖDEL, Max, 97074 Würzburg (DE); PFLAUM, Jens, 97074 Würzburg (DE); LIU, Yongjun, Shenzhen, Guangdong 518129 (CN); YANG, Liang, Shenzhen, Guangdong 518129 (CN)
(74) Representative: Maiwald GmbH
(86) International application number: PCT/CN2022/106674
(87) International publication number: WO 2024/016203

(57) **Abstract**

A pixel unit and a manufacturing method thereof are provided. Light-emitting layers of a plurality of pixel units may be integrally formed, and a sidewall of each pixel unit is not damaged. This can improve light-emitting efficiency of all the pixel units. The pixel unit includes a substrate, a nano antenna and a first electrode connected to the nano antenna that are formed on the substrate, a light-emitting layer formed on the nano antenna and the first electrode, and a second electrode formed on the light-emitting layer. In the pixel unit, driven by voltages provided by the first electrode and the second electrode, the light-emitting layer generates a plurality of light rays having different wavelengths, and emits the plurality of light rays to the nano antenna. Because a resonance band of the nano antenna includes a wavelength of a target light ray that may be emitted by the light-emitting layer, in the plurality of light rays generated by the light-emitting layer, at least one light ray whose wavelength is within the resonance band of the nano antenna, namely, the target light ray, can be enhanced by the nano antenna and transmitted to the substrate, so that the substrate transmits the target light ray to the outside of the pixel unit.

## Description

### TECHNICAL FIELD

This application relates to the field of display technologies, and in particular, to a pixel unit and a manufacturing method thereof.

### BACKGROUND

Display products such as a micro light-emitting diode (micro light-emitting diode, µLED) display and an organic light-emitting diode (organic light-emitting diode, OLED) display have advantages such as self-luminescence, fast response, a wide angle of view, high brightness, bright colors, and lightweight and thinness, and are considered as a next-generation display technology.

In a related technology, a plurality of pixel units included in a display are usually classified into three types. A first type is a pixel unit that may emit a red light ray. A second type is a pixel unit that may emit a green light ray. A third type is a pixel unit that may emit a blue light ray. The pixel units of the three types may be arranged in a staggered manner to form a pixel array. For example, a column of the pixel array may include several pixel units. These pixel units are sequentially a pixel unit that may emit a red light ray, a pixel unit that may emit a green light ray, a pixel unit that may emit a blue light ray, a pixel unit that may emit a red light ray, ..., a pixel unit that may emit a blue light ray, and the like.

Because it is difficult to implement light emission of the three colors by using a same material, light-emitting layers of the pixel units of the three types are manufactured by using different materials. In this case, when the pixel units of the three types are manufactured, the light-emitting layers of the pixel units of the three types need to be cut (in other words, the light-emitting layers of the pixel units of the three types cannot be integrally formed), to smoothly arrange the pixel units of the three types together in the staggered manner to form the pixel array. However, after the light-emitting layer of the pixel unit is cut, a sidewall is damaged. Consequently, light-emitting efficiency of the pixel unit is low.

### SUMMARY

Embodiments of this application provide a pixel unit and a manufacturing method thereof. Light-emitting layers of a plurality of pixel units may be integrally formed, and a sidewall of each pixel unit is not damaged. This can effectively improve light-emitting efficiency of all the pixel units.

According to a first aspect of embodiments of this application, a pixel unit is provided. The pixel unit includes:
a substrate, where a first surface of the substrate may be used as a light-emitting surface of the entire pixel unit, a nano antenna and a first electrode are disposed on a second surface of the substrate, and the first surface of the substrate and the second surface of the substrate are two opposite surfaces;
the nano antenna and the first electrode connected to the nano antenna that are formed on the substrate, where it can be learned from the foregoing description that a first surface of the first electrode is attached to the second surface of the substrate, a first surface of the nano antenna is attached to the second surface of the substrate, a light-emitting layer is disposed on a second surface of the first electrode and a second surface of the nano antenna, the first surface of the first electrode and the second surface of the first electrode are two opposite surfaces, and the first surface of the nano antenna and the second surface of the nano antenna are two opposite surfaces;
the light-emitting layer formed on the nano antenna and the first electrode, where it can be learned from the foregoing description that a first surface of the light-emitting layer is attached to the second surface of the first electrode, the first surface of the light-emitting layer is attached to the second surface of the nano antenna, a second electrode is disposed on a second surface of the light-emitting layer, and the first surface of the light-emitting layer and the second surface of the light-emitting layer are two opposite surfaces; and
the second electrode formed on the light-emitting layer, where it can be learned from the foregoing description that a first surface of the second electrode is attached to the second surface of the light-emitting layer, a second surface of the second electrode may remain exposed or may be provided with another component, and the first surface of the second electrode and the second surface of the second electrode are two opposite surfaces.

It should be noted that a resonance band of the nano antenna may be determined by setting at least one of a material, a shape, and a size of the nano antenna in advance, and the obtained resonance band of the nano antenna may include a wavelength of a target light ray that may be emitted by the light-emitting layer. In this case, when the light-emitting layer works under an action of the first electrode and the second electrode, because the light-emitting layer has a light-emitting band, the light-emitting layer may generate a plurality of light rays (which may also be understood as a plurality of photons or a plurality of rays of light) having different wavelengths, and transmit the plurality of light rays to the nano antenna. Because the resonance band of the nano antenna is determined, in the plurality of light rays, at least one light ray whose wavelength is within the resonance band of the nano antenna, namely, the target light ray, can be enhanced by the nano antenna (actually, "enhanced" mentioned herein means that the nano antenna increases a radiation speed of the target light ray to increase intensity of the target light ray) and transmitted to the substrate, so that the substrate transmits the target light ray to the outside of the pixel unit. The rest light rays whose wavelengths are outside the resonance band of the nano antenna are suppressed by the nano antenna, and are difficult to be transmitted to the substrate (actually, "suppressed" mentioned herein means that this part of light rays is not enhanced by the nano antenna, and when compared with the enhanced target light ray, this part of light rays seems to be "suppressed"). In this way, the pixel unit can successfully emit the target light ray. The wavelength of the target light ray is selected. In other words, a color of the target light ray is selected. Therefore, the pixel unit can emit a light ray of a specific color.

The pixel unit includes the substrate, the nano antenna and the first electrode connected to the nano antenna that are formed on the substrate, the light-emitting layer formed on the nano antenna and the first electrode, and the second electrode formed on the light-emitting layer. In the pixel unit, driven by voltages provided by the first electrode and the second electrode, the light-emitting layer generates the plurality of light rays having different wavelengths, and emits the plurality of light rays to the nano antenna. Because the resonance band of the nano antenna includes the wavelength of the target light ray that may be emitted by the light-emitting layer, in the plurality of light rays generated by the light-emitting layer, at least one light ray whose wavelength is within the resonance band of the nano antenna, namely, the target light ray, can be enhanced by the nano antenna and transmitted to the substrate, so that the substrate transmits the target light ray to the outside of the pixel unit. The rest light rays whose wavelengths are outside the resonance band of the nano antenna are suppressed by the nano antenna, and are difficult to be transmitted to the substrate. In this way, the pixel unit can successfully emit the target light ray. The wavelength of the target light ray is selected. In other words, the color of the target light ray is selected. Therefore, the pixel unit can emit the light ray of the specific color. It can be learned that, in a display constructed by the plurality of pixel units provided in embodiments of this application, each pixel unit may select, by using a nano antenna of the pixel unit, a light ray having a specific wavelength (a color) to be emitted. In this way, light-emitting layers of the plurality of pixel units may be made of a same material. In other words, the light-emitting layers of the plurality of pixel units may be integrally formed. Therefore, a sidewall of each pixel unit is not damaged. This can effectively improve light-emitting efficiency of all the pixel units.

In a possible implementation, both the first electrode and the nano antenna are of bar-shaped structures, and one end of the first electrode is connected to a middle part of the nano antenna. In the foregoing implementation, both the first electrode and the nano antenna may be configured as bar-shaped structures, and a connection part between the first electrode and the nano antenna is disposed in the middle of the nano antenna. This facilitates manufacturing of the pixel unit, and can further avoid impact of the first electrode on resonance of the nano antenna.

In a possible implementation, the first electrode and the nano antenna are disposed at a same layer. Certainly, the first electrode and the nano antenna may alternatively be disposed at different layers in a stacked manner. For example, the first electrode is disposed on the nano antenna. For another example, the nano antenna is disposed on the first electrode.

In a possible implementation, a second-order resonance band of the nano antenna includes the wavelength of the target light ray that may be emitted by the light-emitting layer. In the foregoing implementation, the light-emitting band of the light-emitting layer may be set to a range between adjacent-order resonance bands of the nano antenna. To be specific, a start wavelength of the light-emitting band of the light-emitting layer may be a wavelength between the second-order resonance band and a third-order resonance band of the nano antenna, and an end wavelength of the light-emitting band of the light-emitting layer may be a wavelength between a first-order resonance band and the second-order resonance band of the nano antenna. It can be learned that the light-emitting band of the light-emitting layer may include only the entire second-order resonance band of the nano antenna. In this case, the nano antenna may excite, from the plurality of light rays that are emitted by the light-emitting layer and that have different wavelengths, the target light ray whose wavelength falls within the second-order resonance band of the nano antenna. This can avoid mutual interference between adjacent-order resonance of the nano antenna, and can improve purity of the light ray emitted by the pixel unit.

In a possible implementation, a polarization direction of the nano antenna during resonance is the same as a polarization direction of the target light ray. In the foregoing implementation, the polarization direction of the nano antenna during resonance may be determined by setting the shape of the nano antenna in advance, and the obtained polarization direction of the nano antenna during resonance is the same as the polarization direction of the target light ray that may be emitted by the light-emitting layer. It can be learned that the nano antenna may excite, from the plurality of light rays that are emitted by the light-emitting layer and that have different wavelengths and different polarization directions, the target light ray whose wavelength falls within the resonance band of the nano antenna and whose polarization direction is the same as the polarization direction of the nano antenna during resonance.

In a possible implementation, a direction in which the nano antenna emits a light ray during resonance is the same as an emission direction of the target light ray obtained after the target light ray passes through the nano antenna. In the foregoing implementation, the light-emitting direction of the nano antenna during resonance (namely, the direction in which the nano antenna emits a light ray during resonance) may be determined by setting the shape of the nano antenna in advance, and the obtained light-emitting direction of the nano antenna during resonance is the same as an emission direction of the target light ray that may be emitted by the light-emitting layer (namely, the emission direction of the target light ray obtained after the target light ray passes through the nano antenna). It can be learned that the nano antenna may excite, from the plurality of light rays that are emitted by the light-emitting layer and that have different wavelengths and different emission directions, the target light ray whose wavelength falls within the resonance band of the nano antenna and whose emission direction is the same as the light-emitting direction of the nano antenna during resonance.

In a possible implementation, the light-emitting layer includes an exciton recombination layer, to emit various light rays under the voltages applied by the first electrode and the second electrode.

In a possible implementation, the light-emitting layer further includes at least one of the following: a hole injection layer, a hole transport layer, an electron blocking layer, an electron injection layer, an electron transport layer, or a hole blocking layer. If the first electrode is an anode electrode and the second electrode is a cathode electrode, at least one of the hole injection layer, the hole transport layer, or the electron blocking layer is formed between the exciton recombination layer and the nano antenna, and at least one of the electron injection layer, the electron transport layer, or the hole blocking layer is formed between the exciton recombination layer and the second electrode. If the first electrode is a cathode electrode and the second electrode is an anode electrode, at least one of the electron injection layer, the electron transport layer, or the hole blocking layer is formed between the exciton recombination layer and the nano antenna, and at least one of the hole injection layer, the hole transport layer, or the electron blocking layer is formed between the exciton recombination layer and the second electrode. In the foregoing implementation, the light-emitting layer may further include one or more of the following: the hole injection layer, the hole transport layer, the electron blocking layer, the electron injection layer, the electron transport layer, or the hole blocking layer. These layers can facilitate migration of a hole or an electron, or suppress migration of the hole or the electron. It can be learned that, when the first electrode and the second electrode apply a specific voltage to the light-emitting layer, the hole and the electron move toward each other. To be specific, the hole moves from the first electrode to the second electrode (it is assumed that the first electrode is an anode electrode and the second electrode is a cathode electrode), and the electron moves from the second electrode to the first electrode. The hole and the electron recombine with each other at the exciton recombination layer to emit a light ray. This belongs to spontaneous emission. In this case, the light ray generated by the light-emitting layer is transmitted to the nano antenna, acts with the nano antenna connected to the first electrode, and then is transmitted by the nano antenna to the substrate.

In a possible implementation, a distance between the exciton recombination layer and the nano antenna is less than or equal to 20 nm. In the foregoing implementation, the distance between the exciton recombination layer and the nano antenna may be set to be less than or equal to 20 nm, to achieve an effect of strong coupling between the exciton recombination layer and the nano antenna.

In a possible implementation, the pixel unit further includes an insulating medium, and the insulating medium covers only the first electrode. In the foregoing implementation, the surface of the first electrode may be coated with the insulating medium, so that the insulating medium covers only the first electrode. In this case, the first electrode and the light-emitting layer are separated by the insulating medium. The first electrode and the light-emitting layer are not in contact with each other, and only the nano antenna is in contact with the light-emitting layer. In this way, almost all the light rays emitted by the light emitting layer are emitted to the nano antenna. In this way, impact of the first electrode on resonance of the nano antenna can be prevented, and a light-emitting position of the entire pixel unit can be limited to an area in which the nano antenna is located.

In a possible implementation, the first electrode is an anode electrode and the second electrode is a cathode electrode, or the first electrode is a cathode electrode and the second electrode is an anode electrode.

According to a second aspect of embodiments of this application, a pixel unit manufacturing method is provided. The method includes: forming, on a substrate, a nano antenna and a first electrode connected to the nano antenna; forming a light-emitting layer on the nano antenna and the first electrode that are connected, where a resonance wavelength of the nano antenna is equal to a wavelength of a target light ray that may be emitted by the light-emitting layer, and the target light ray is a light ray emitted by the pixel unit to the outside; and forming a second electrode on the light-emitting layer.

The pixel unit manufactured according to the foregoing method includes the substrate, the nano antenna and the first electrode connected to the nano antenna that are formed on the substrate, the light-emitting layer formed on the nano antenna and the first electrode, and the second electrode formed on the light-emitting layer. In the pixel unit, driven by voltages provided by the first electrode and the second electrode, the light-emitting layer generates a plurality of light rays having different wavelengths, and emits the plurality of light rays to the nano antenna. Because the resonance band of the nano antenna includes the wavelength of the target light ray that may be emitted by the light-emitting layer, in the plurality of light rays generated by the light-emitting layer, at least one light ray whose wavelength is within the resonance band of the nano antenna, namely, the target light ray, can be enhanced by the nano antenna and transmitted to the substrate, so that the substrate transmits the target light ray to the outside of the pixel unit. The rest light rays whose wavelengths are outside the resonance band of the nano antenna are suppressed by the nano antenna, and are difficult to be transmitted to the substrate. In this way, the pixel unit can successfully emit the target light ray. The wavelength of the target light ray is selected. In other words, a color of the target light ray is selected. Therefore, the pixel unit can emit the light ray of the specific color. It can be learned that, in a display constructed by a plurality of pixel units provided in embodiments of this application, each pixel unit may select, by using a nano antenna of the pixel unit, a light ray having a specific wavelength (a color) to be emitted. In this way, light-emitting layers of the plurality of pixel units may be made of a same material. In other words, the light-emitting layers of the plurality of pixel units may be integrally formed. Therefore, a sidewall of each pixel unit is not damaged. This can effectively improve light-emitting efficiency of all the pixel units.

In a possible implementation, both the first electrode and the nano antenna are of bar-shaped structures, and one end of the first electrode is connected to a middle part of the nano antenna.

In a possible implementation, the first electrode and the nano antenna are disposed at a same layer.

In a possible implementation, a second-order resonance band of the nano antenna includes the wavelength of the target light ray that may be emitted by the light-emitting layer.

In a possible implementation, a polarization direction of the nano antenna during resonance is the same as a polarization direction of the target light ray.

In a possible implementation, a direction in which the nano antenna emits a light ray during resonance is the same as an emission direction of the target light ray obtained after the target light ray passes through the nano antenna.

In a possible implementation, the forming a light-emitting layer on the nano antenna and the first electrode that are connected includes: forming an exciton recombination layer on the nano antenna and the first electrode that are connected.

In a possible implementation, the forming a light-emitting layer on the nano antenna and the first electrode that are connected further includes: forming at least one of an electron injection layer, an electron transport layer, or a hole blocking layer between the exciton recombination layer and the nano antenna, and forming at least one of a hole injection layer, a hole transport layer, or an electron blocking layer between the exciton recombination layer and the second electrode; or forming at least one of an electron injection layer, an electron transport layer, or a hole blocking layer between the exciton recombination layer and the nano antenna, and forming at least one of a hole injection layer, a hole transport layer, or an electron blocking layer between the exciton recombination layer and the second electrode.

In a possible implementation, a distance between the exciton recombination layer and the nano antenna is less than or equal to 20 nm.

In a possible implementation, the method further includes: forming an insulating medium on the first electrode, where the insulating medium covers only the first electrode.

In a possible implementation, the first electrode is an anode electrode and the second electrode is a cathode electrode, or the first electrode is a cathode electrode and the second electrode is an anode electrode.

According to a third aspect of embodiments of this application, a pixel array is provided. The pixel array includes a plurality of pixel units according to any one of the first aspect or the possible implementations of the first aspect. Light-emitting layers of the plurality of pixel units are made of a same material. Therefore, light rays emitted by the light-emitting layers of the plurality of pixel units are the same.

In a possible implementation, the light-emitting layers of the plurality of pixel units are integrally formed.

According to a fourth aspect of embodiments of this application, a display is provided. The display includes a driver chip and the pixel array according to the third aspect, and the driver chip is configured to provide a drive voltage for the pixel array.

According to a fifth aspect of embodiments of this application, an electronic device is provided. The electronic device includes a processor, a memory, and the display according to the fourth aspect.

The pixel unit provided in embodiments of this application includes the substrate, the nano antenna and the first electrode connected to the nano antenna that are formed on the substrate, the light-emitting layer formed on the nano antenna and the first electrode, and the second electrode formed on the light-emitting layer. In the pixel unit, driven by voltages provided by the first electrode and the second electrode, the light-emitting layer generates a plurality of light rays having different wavelengths, and emits the plurality of light rays to the nano antenna. Because the resonance band of the nano antenna includes the wavelength of the target light ray that may be emitted by the light-emitting layer, in the plurality of light rays generated by the light-emitting layer, at least one light ray whose wavelength is within the resonance band of the nano antenna, namely, the target light ray, can be enhanced by the nano antenna and transmitted to the substrate, so that the substrate transmits the target light ray to the outside of the pixel unit. The rest light rays whose wavelengths are outside the resonance band of the nano antenna are suppressed by the nano antenna, and are difficult to be transmitted to the substrate. In this way, the pixel unit can successfully emit the target light ray. The wavelength of the target light ray is selected. In other words, a color of the target light ray is selected. Therefore, the pixel unit can emit the light ray of the specific color. It can be learned that, in a display constructed by a plurality of pixel units provided in embodiments of this application, each pixel unit may select, by using a nano antenna of the pixel unit, a light ray having a specific wavelength (a color) to be emitted. In this way, light-emitting layers of the plurality of pixel units may be made of a same material. In other words, the light-emitting layers of the plurality of pixel units may be integrally formed. Therefore, a sidewall of each pixel unit is not damaged. This can effectively improve light-emitting efficiency of all the pixel units.

### BRIEF DESCRIPTION OF DRAWINGS

FIG. 1 is a diagram of a structure of a pixel unit according to an embodiment of this application;
FIG. 2 is a diagram of a relationship between a length of a nano antenna and a resonance center wavelength of the nano antenna according to an embodiment of this application;
FIG. 3 is a diagram of a structure of a nano antenna according to an embodiment of this application;
FIG. 4 is a diagram of another structure of a nano antenna according to an embodiment of this application;
FIG. 5 is a diagram of a connection between a first electrode and a nano antenna according to an embodiment of this application;
FIG. 6 is a diagram of a light-emitting band of a light-emitting layer according to an embodiment of this application;
FIG. 7 is a diagram of another structure of a pixel unit according to an embodiment of this application;
FIG. 8 is a schematic flowchart of a pixel unit manufacturing method according to an embodiment of this application;
FIG. 9 is a diagram of a manufacturing procedure of a pixel unit according to an embodiment of this application;
FIG. 10 is a diagram of another manufacturing procedure of a pixel unit according to an embodiment of this application;
FIG. 11 is a diagram of another manufacturing procedure of a pixel unit according to an embodiment of this application;
FIG. 12 is a diagram of another manufacturing procedure of a pixel unit according to an embodiment of this application;
FIG. 13 is a diagram of another manufacturing procedure of a pixel unit according to an embodiment of this application;
FIG. 14 is a diagram of another manufacturing procedure of a pixel unit according to an embodiment of this application;
FIG. 15 is a diagram of an application example of a pixel array according to an embodiment of this application;
FIG. 16 is a diagram of another application example of a pixel array according to an embodiment of this application;
FIG. 17 is a diagram of another application example of a pixel array according to an embodiment of this application;
FIG. 18 is a diagram of another application example of a pixel array according to an embodiment of this application; and
FIG. 19 is a diagram of another application example of a pixel array according to an embodiment of this application.

### DESCRIPTION OF EMBODIMENTS

Embodiments of this application provide a pixel unit and a manufacturing method thereof. Light-emitting layers of a plurality of pixel units may be integrally formed, and a sidewall of each pixel unit is not damaged. This can effectively improve light-emitting efficiency of all the pixel units.

In the specification, claims, and accompanying drawings of this application, the terms "first", "second", and the like are intended to distinguish between similar objects but do not necessarily indicate a specific order or sequence. It should be understood that the terms used in such a way are interchangeable in proper circumstances, which is merely a discrimination manner that is used when objects having a same attribute are described in embodiments of this application. In addition, the terms "include", "have", and any other variants are intended to cover a non-exclusive inclusion, so that a process, method, system, product, or device that includes a series of units is not necessarily limited to those units, but may include other units not expressly listed or inherent to the process, method, system, product, or device.

Display products such as a µLED display and an OLED display have advantages such as self-luminescence, fast response, a wide angle of view, high brightness, bright colors, and lightweight and thinness, and are considered as a next-generation display technology.

In a related technology, to display a colorful image, the display needs pixel units that can emit a red light ray, a green light ray, and a blue light ray. Therefore, the plurality of pixel units included in the display may be classified into three types. A first type is a pixel unit that may emit a red light ray. A second type is a pixel unit that may emit a green light ray. A third type is a pixel unit that may emit a blue light ray. The pixel units of the three types may be arranged in a staggered manner to form a pixel array. For example, any column of the pixel array may include several pixel units. These pixel units are sequentially a pixel unit that may emit a red light ray, a pixel unit that may emit a green light ray, a pixel unit that may emit a blue light ray, a pixel unit that may emit a red light ray, ..., a pixel unit that may emit a blue light ray, and the like.

Because it is difficult to implement light emission of the three colors by using a same material, light-emitting layers of the pixel units of the three types are manufactured by using different materials. In this case, when the pixel units of the three types are manufactured, the light-emitting layers of the pixel units of the three types need to be cut (in other words, the light-emitting layers of the pixel units of the three types are separately formed, instead of being integrally formed), to smoothly arrange the pixel units of the three types together in the staggered manner to form the pixel array. However, after the light-emitting layer of the pixel unit is cut, a sidewall is damaged. To be specific, after the light-emitting layer of the pixel unit is cut, a side surface exists, and current leakage occurs on the side surface of the light-emitting layer. Consequently, currents used for light emission are reduced, and overall light-emitting efficiency of the pixel unit is low.

Further, in the related technology, the light-emitting layers of the pixel units of the three types are manufactured by using different materials, and voltages required by the different materials during light emission are usually different. Therefore, for the display constructed based on the pixel units of the three types, due to a difference between the materials of the light-emitting layers and a difference between the voltages required by the materials, an overall manufacturing process of the display is very complex, and manufacturing costs are high.

Further, in the related technology, limited by the material of the light-emitting layer of the pixel unit, a spontaneous emission linewidth of the pixel unit is usually large. In other words, a band of the light ray that may be emitted by the pixel unit (the light-emitting layer of the pixel unit) is usually wide. Consequently, color purity of a light ray finally emitted by the pixel unit is inadequate. This impairs user experience.

Further, in the related technology, to meet requirements of some specific scenarios, the display needs to implement a polarization display effect or a directional display effect. In this case, a polarization filter or a directional filter is added to the pixel unit in the display, to cooperate with the pixel unit to implement a polarized light ray or a directional light ray. However, these additional filters tend to weaken intensity of the light ray emitted by the pixel unit, resulting in reduced light-emitting efficiency of the pixel unit.

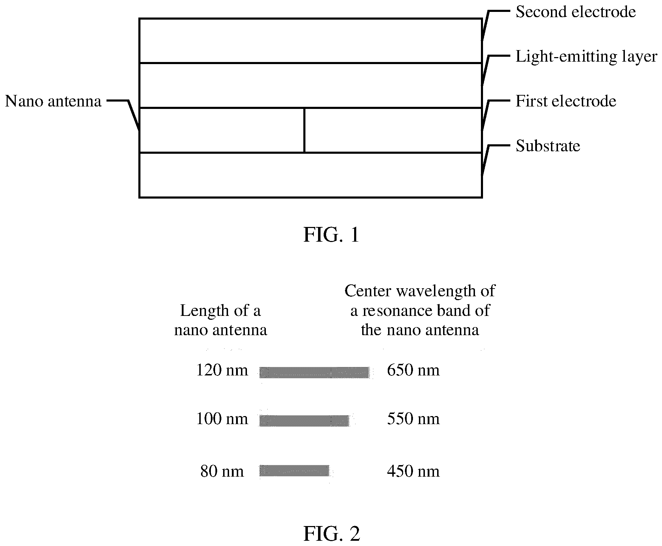

To resolve the foregoing problems, embodiments of this application provide a new pixel unit, a pixel array constructed based on the new pixel unit, and a display constructed based on the pixel array. The following first describes the pixel unit provided in embodiments of this application. FIG. 1 is a diagram of a structure of the pixel unit according to an embodiment of this application. As shown in FIG. 1, the pixel unit includes a substrate, a nano antenna and a first electrode (which may also be referred to as a first electrode line) that are formed on the substrate, a light-emitting layer formed on the nano antenna and the first electrode, and a second electrode (which may also be referred to as a second electrode line) formed on the light-emitting layer. The following describes the components.

The substrate is usually made of a transparent material (for example, glass or plastic). A first surface of the substrate may be used as a light-emitting surface of the entire pixel unit. The nano antenna and the first electrode are disposed on a second surface of the substrate. The first surface of the substrate and the second surface of the substrate are two opposite surfaces.

The nano antenna is similar to an antenna in the field of wireless communication, and is usually made of a metal material (for example, metal like gold, silver, aluminum, or copper) or another conductive material. The nano antenna has a resonance effect on a light ray having specific characteristics. It should be noted that these characteristics may include one or more of the following: a wavelength, polarization, a direction, and the like. In other words, when some light rays act on (hit) the nano antenna, if resonance characteristics of the nano antenna are consistent with characteristics of the light rays, the nano antenna may increase a (radiation) speed of the light rays, and further increase intensity of the light rays. If the resonance characteristics of the nano antenna are inconsistent with the characteristics of the light rays, the nano antenna suppresses the light rays.

Specifically, the material, a shape, and a size of the nano antenna determine a resonance band of the nano antenna. For a nano antenna of a specific material and in a specific shape, a size of the nano antenna is directly proportional to a resonance band of the nano antenna. In other words, a larger size of the nano antenna indicates a larger center wavelength of the resonance band of the nano antenna. For example, as shown in FIG. 2 (FIG. 2 is a diagram of a relationship between a length of a nano antenna and a resonance center wavelength of the nano antenna according to an embodiment of this application), it is assumed that there are a nano antenna a, a nano antenna b, and a nano antenna c. Materials for manufacturing the three nano antennas are the same, and shapes of the three nano antennas are all transverse bars. A length of the nano antenna a is 80 nm; a length of the nano antenna b is 100 nm; and a length of the nano antenna c is 120 nm. Therefore, a center wavelength of a resonance band of the nano antenna a is 450 nm; a center wavelength of a resonance band of the nano antenna b is 550 nm; and a center wavelength of a resonance band of the nano antenna c is 650 nm.

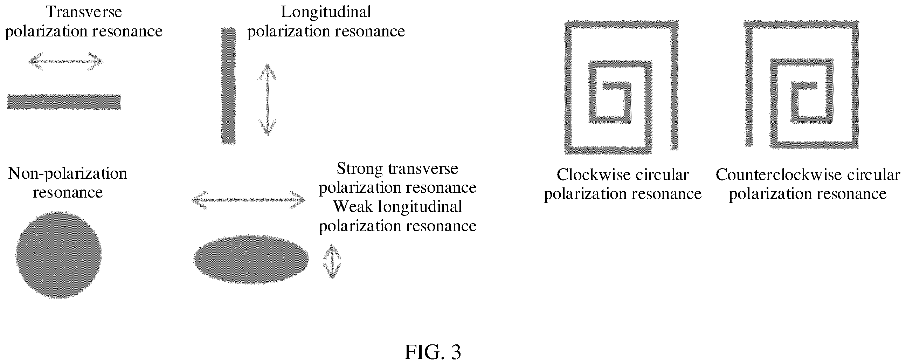

The shape of the nano antenna determines a polarization direction of the nano antenna during resonance (in other words, the nano antenna undergoes resonance in a direction or some directions). Generally, an extension direction of the nano antenna is the polarization direction of the nano antenna during resonance. For a nano antenna that does not have an obvious extension direction, it may be considered that the nano antenna does not have a polarization direction during resonance. For example, as shown in FIG. 3 (FIG. 3 is a diagram of a structure of a nano antenna according to an embodiment of this application), for a transverse bar-shaped nano antenna, a polarization direction of the transverse bar-shaped nano antenna during resonance is a transverse direction (in other words, the nano antenna undergoes transverse polarization resonance). For a longitudinal bar-shaped nano antenna, a polarization direction of the longitudinal bar-shaped nano antenna during resonance is a longitudinal direction (in other words, the nano antenna undergoes longitudinal polarization resonance). For a circular nano antenna (or a square nano antenna, or the like), there is no polarization direction during resonance (in other words, the nano antenna undergoes non-polarization resonance). For an elliptical nano antenna, a polarization direction of the elliptical nano antenna during resonance includes both a transverse component and a longitudinal component (in other words, the nano antenna undergoes strong transverse polarization resonance and weak longitudinal polarization resonance). For a right helical nano antenna, a polarization direction of the right helical nano antenna during resonance is clockwise rotation (in other words, the nano antenna undergoes clockwise circular polarization resonance). For a left helical nano antenna, a polarization direction of the right helical nano antenna during resonance is counterclockwise rotation (in other words, the nano antenna undergoes counterclockwise circular polarization resonance).

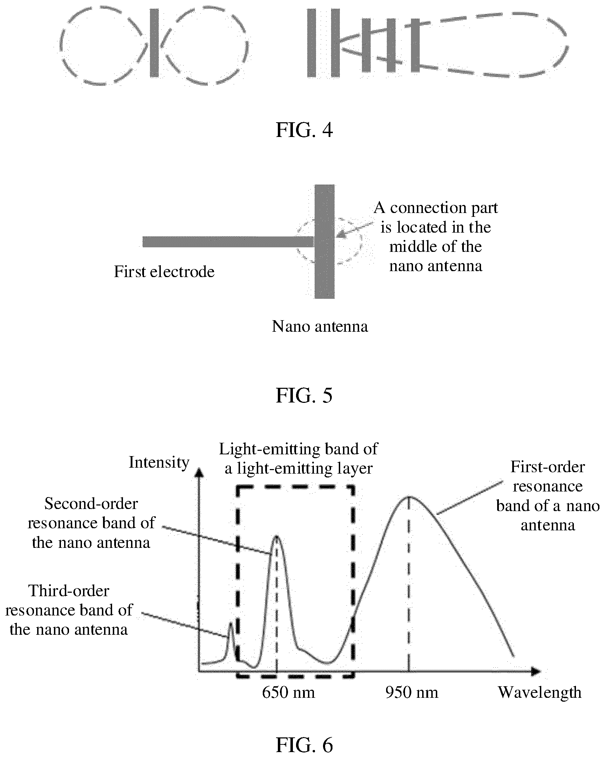

The shape of the nano antenna determines a light-emitting direction of the nano antenna during resonance (namely, a direction in which the nano antenna emits a light ray during resonance). For example, as shown in FIG. 4 (FIG. 4 is a diagram of another structure of a nano antenna according to an embodiment of this application), when the nano antenna is a Yagi antenna, the nano antenna may implement light emitting in a specific direction during resonance.

The first electrode is usually made of a metal material (for example, metal like gold, silver, aluminum, or copper) or another conductive material. The first electrode is connected to the nano antenna. The first electrode and the nano antenna may be disposed at a same layer, and thicknesses of the first electrode and the nano antenna may be consistent (it should be noted that the first electrode and the nano antenna may alternatively be disposed at different layers in a stacked manner; for example, the first electrode is disposed on the nano antenna; and for another example, the nano antenna is disposed on the first electrode). It can be learned from the foregoing description that a first surface of the first electrode is attached to the second surface of the substrate. A first surface of the nano antenna is attached to the second surface of the substrate. A light-emitting layer is disposed on a second surface of the first electrode and a second surface of the nano antenna. The first surface of the first electrode and the second surface of the first electrode are two opposite surfaces, and the first surface of the nano antenna and the second surface of the nano antenna are two opposite surfaces.

The light-emitting layer may also be referred to as an electroluminescent laminate. It can be learned from the foregoing description that a first surface of the light-emitting layer is attached to the second surface of the first electrode. The first surface of the light-emitting layer is attached to the second surface of the nano antenna. A second electrode is disposed on a second surface of the light-emitting layer. The first surface of the light-emitting layer and the second surface of the light-emitting layer are two opposite surfaces. It can be learned that the light-emitting layer is disposed between the first electrode and the second electrode. Therefore, the light-emitting layer can generate the target light ray under a voltage jointly applied by the first electrode and the second electrode, and transmit the target light ray to the nano antenna, and then the nano antenna transmits the target light ray to the substrate, so that the substrate transmits the target light ray.

The second electrode is usually made of a metal material (for example, metal like gold, silver, aluminum, or copper) or another conductive material. It can be learned from the foregoing description that a first surface of the second electrode is attached to the second surface of the light-emitting layer. A second surface of the second electrode may remain exposed or may be provided with another component, and details are not described herein (the first surface of the second electrode and the second surface of the second electrode are two opposite surfaces).

It should be noted that a resonance band of the nano antenna may be determined by setting at least one of the material, the shape, and the size of the nano antenna in advance, and the obtained resonance band of the nano antenna may include a wavelength of the target light ray that may be emitted by the light-emitting layer. In this case, when the light-emitting layer works under an action of the first electrode and the second electrode, because the light-emitting layer has a light-emitting band, the light-emitting layer may generate a plurality of light rays having different wavelengths, and transmit the plurality of light rays to the nano antenna. Because the resonance band of the nano antenna is determined, in the plurality of light rays, at least one light ray whose wavelength is within the resonance band of the nano antenna, namely, the target light ray, can be enhanced by the nano antenna and transmitted to the substrate, so that the substrate transmits the target light ray to the outside of the pixel unit. The rest light rays whose wavelengths are outside the resonance band of the nano antenna are suppressed by the nano antenna, and are difficult to be transmitted to the substrate. In this way, the pixel unit can successfully emit the target light ray. The wavelength of the target light ray is selected. In other words, a color of the target light ray is selected. Therefore, the pixel unit can emit the light ray of the specific color.

For example, the light-emitting layer of the pixel unit may emit a light ray with a wavelength of 400 nm, a light ray with a wavelength of 401 nm, ..., and a light ray with a wavelength of 800 nm (in other words, the light-emitting band of the light-emitting layer is 400 nm to 800 nm) to the nano antenna. Because the resonance band of the nano antenna is 640 nm to 660 nm (for example, the resonance band of the nano antenna may be set to 640 nm to 660 nm by setting the length of the nano antenna), the nano antenna may enhance the light ray with a wavelength of 640 nm, the light ray with a wavelength of 641 nm, ..., and the light ray with a wavelength of 660 nm, and transmit the light rays to the substrate. At the same time, the nano antenna may also suppress the light ray with a wavelength of 400 nm, the light ray with a wavelength of 401 nm, ..., the light ray with a wavelength of 639 nm, the light ray with a wavelength of 661 nm, ..., and the light ray with a wavelength of 800 nm, to prevent these light rays from being transmitted to the substrate. In this way, the substrate may emit the light ray with a wavelength of 640 nm, the light ray with a wavelength of 641 nm, ..., and the light ray with a wavelength of 660 nm. In other words, the pixel unit emits red light rays.

In a possible implementation, to facilitate manufacturing and avoid impact of the first electrode on resonance of the nano antenna, both the first electrode and the nano antenna may be of bar-shaped structures, and one end of the first electrode is connected to a middle part of the nano antenna. For example, as shown in FIG. 5 (FIG. 5 is a diagram of a connection between the first electrode and the nano antenna according to an embodiment of this application), a connection part between the first electrode and the nano antenna may be disposed in the middle of the nano antenna.

In a possible implementation, the nano antenna actually has a plurality of resonance bands, including a first-order resonance band, a second-order resonance band, and a third-order resonance band. The first-order resonance band has a largest center wavelength and a largest response amplitude, but a range of the first-order resonance band is wide. If the first-order resonance band is used to filter light rays, purity of the light ray emitted by the pixel unit may be inadequate. On the basis of this, a high-order resonance band of the nano antenna may be used to filter the light rays. A higher order of the resonance band indicates a smaller center wavelength, a smaller response amplitude, and a narrower band range. Therefore, both the response amplitude and the band range may be considered when the high-order resonance band of the nano antenna is selected. For example, for a nano antenna with a length of 120 nm, a center wavelength of a first-order resonance band of the nano antenna is 650 nm, and a center wavelength of a second-order resonance band of the nano antenna is 480 nm. A linewidth (a range) of the first-order resonance band is approximately 300 nm, while a linewidth of the second-order resonance band is only 20 nm.

To avoid mutual interference between adjacent-order resonance, the light-emitting band of the light-emitting layer may be set to a range between adjacent-order resonance bands of the nano antenna. To be specific, a start wavelength of the light-emitting band of the light-emitting layer may be a wavelength between the second-order resonance band and a third-order resonance band of the nano antenna, and an end wavelength of the light-emitting band of the light-emitting layer may be a wavelength between the first-order resonance band and the second-order resonance band of the nano antenna. For example, as shown in FIG. 6 (FIG. 6 is a diagram of a light-emitting band of a light-emitting layer according to an embodiment of this application), it is assumed that a center wavelength of a first-order resonance band of a nano antenna is 950 nm, a center wavelength of a second-order resonance band of the nano antenna is 650 nm, and a center wavelength of a third-order resonance band of the nano antenna is 300 nm. If the second-order resonance band of the nano antenna is used to filter light rays, the light-emitting layer may be manufactured by using a material whose light-emitting band ranges from 400 nm to 800 nm, to avoid impact of adjacent-order resonance.

It can be learned that the light-emitting band of the light-emitting layer may include only the entire second-order resonance band of the nano antenna. In this case, the nano antenna may excite, from a plurality of light rays that are emitted by the light-emitting layer and that have different wavelengths, a target light ray whose wavelength falls within the second-order resonance band of the nano antenna. In other words, the second-order resonance band of the nano antenna includes the wavelength of the target light ray that may be emitted by the light-emitting layer. Specifically, after the light-emitting layer emits the plurality of light rays with different wavelengths to the nano antenna, in the plurality of light rays, at least one light ray whose wavelength is within the second-order resonance band of the nano antenna, namely, the target light ray, can be enhanced by the nano antenna and transmitted to a substrate, so that the substrate transmits the target light ray to the outside of a pixel unit. The rest light rays whose wavelengths are outside the second-order resonance band of the nano antenna are suppressed by the nano antenna, and are difficult to be transmitted to the substrate.

In a possible implementation, a polarization direction of the nano antenna during resonance may be determined by setting a shape of the nano antenna in advance, and the obtained polarization direction of the nano antenna during resonance is the same as a polarization direction of the target light ray that may be emitted by the light-emitting layer. It can be learned that the nano antenna may excite, from the plurality of light rays that are emitted by the light-emitting layer and that have different wavelengths and different polarization directions, the target light ray whose wavelength falls within the resonance band of the nano antenna and whose polarization direction is the same as the polarization direction of the nano antenna during resonance. For example, it is assumed that a resonance band of the nano antenna is 640 nm to 660 nm, and a polarization direction of the nano antenna during resonance is a transverse direction. The light-emitting layer of the pixel unit may emit, to the nano antenna, a light ray whose wavelength is 400 nm and whose polarization direction is the transverse direction, ..., a light ray whose wavelength is 650 nm and whose polarization direction is the transverse direction, a light ray whose wavelength is 651 nm and whose polarization direction is a longitudinal direction, ..., and a light ray whose wavelength is 800 nm and whose polarization direction is the longitudinal direction. In this case, the nano antenna may enhance the light ray whose wavelength is 640 nm and whose polarization direction is the transverse direction, the light ray whose wavelength is 641 nm and whose polarization direction is the transverse direction, ..., and the light ray whose wavelength is 650 nm and whose polarization direction is the transverse direction, and transmits these light rays to the substrate. At the same time, the nano antenna may also suppress the rest light rays (the rest light rays are either light rays whose wavelengths are outside 640 nm to 660 nm, or light rays whose polarization directions are not the transverse direction), to prevent these light rays from being transmitted to the substrate. In this way, the substrate may emit the light ray whose wavelength is 640 nm and whose polarization direction is the transverse direction, the light ray whose wavelength is 641 nm and whose polarization direction is the transverse direction, ..., and the light ray whose wavelength is 650 nm and whose polarization direction is the transverse direction. In other words, the pixel unit emits light rays whose colors are red and whose polarization directions are the transverse direction.

In a possible implementation, a light-emitting direction of the nano antenna during resonance may be determined by setting the shape of the nano antenna in advance, and the obtained light-emitting direction of the nano antenna during resonance is the same as an emission direction of the target light ray that may be emitted by the light-emitting layer (the emission direction of the target light ray may also be understood as an emission direction of the target light ray obtained after the target light ray passes through the nano antenna). It can be learned that the nano antenna may excite, from the plurality of light rays that are emitted by the light-emitting layer and that have different wavelengths and different emission directions, the target light ray whose wavelength falls within the resonance band of the nano antenna and whose emission direction is the same as the light-emitting direction of the nano antenna during resonance. For example, it is assumed that a resonance band of the nano antenna is 640 nm to 660 nm, and a light-emitting direction of the nano antenna during resonance is a horizontal direction. The light-emitting layer of the pixel unit may emit, to the nano antenna, a light ray whose wavelength is 400 nm and whose polarization direction is the horizontal direction, ..., a light ray whose wavelength is 650 nm and whose emission direction is the horizontal direction, a light ray whose wavelength is 651 nm and whose emission direction is an inclined direction, ..., and a light ray whose wavelength is 800 nm and whose emission direction is the inclined direction. In this case, the nano antenna may enhance the light ray whose wavelength is 640 nm and whose emission direction is the horizontal direction, the light ray whose wavelength is 641 nm and whose emission direction is the horizontal direction, ..., and the light ray whose wavelength is 650 nm and whose emission direction is the horizontal direction, and transmit these light rays to the substrate. At the same time, the nano antenna may also suppress the rest light rays (the rest light rays are either light rays whose wavelengths are outside 640 nm to 660 nm, or light rays whose emission directions are not the horizontal direction), to prevent these light rays from being transmitted to the substrate. In this way, the substrate may emit the light ray whose wavelength is 640 nm and whose emission direction is the horizontal direction, the light ray whose wavelength is 641 nm and whose emission direction is the horizontal direction, ..., and the light ray whose wavelength is 650 nm and whose emission direction is the horizontal direction. In other words, the pixel unit emits light rays whose colors are red and whose emission directions are the horizontal direction.

In a possible implementation, the light-emitting layer includes an exciton recombination layer, and the exciton recombination layer includes one or more light-emitting materials. Specifically, the exciton recombination layer may have a plurality of structures: (1) The exciton recombination layer may include a plurality of layers of different materials, and each layer of material may emit a light ray of a specific color under an action of a voltage. For example, the exciton recombination layer may include three layers that are sequentially stacked. After the voltage is applied, the three layers may separately emit a red light ray, a green light ray, and a blue light ray. (2) The exciton recombination layer may be made of a mixed light-emitting material, and may emit a light ray in a wide band after a voltage is applied, including a red light ray, a green light ray, a blue light ray, and the like. It should be noted that the light-emitting material used to manufacture the exciton recombination layer may include at least one of the following: zinc phthalocyanine, zinc sulfide doped with copper, 8-hydroxyquinolinato aluminum, and the like.

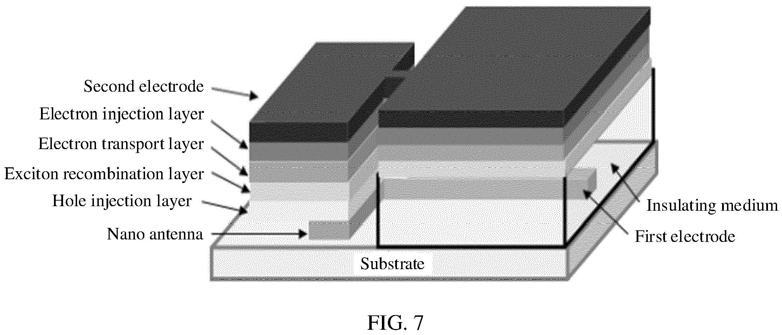

In a possible implementation, the light-emitting layer may further include one or more of the following: the hole injection layer, the hole transport layer, the electron blocking layer, the electron injection layer, the electron transport layer, or the hole blocking layer. These layers can facilitate migration of a hole or an electron, or suppress migration of the hole or the electron. Generally, there are the following two cases: (1) If the first electrode is an anode electrode and the second electrode is a cathode electrode, at least one of the hole injection layer, the hole transport layer, or the electron blocking layer may be disposed between the exciton recombination layer and the nano antenna, and at least one of the electron injection layer, the electron transport layer, or the hole blocking layer may be further disposed between the exciton recombination layer and the second electrode. (2) If the first electrode is a cathode electrode and the second electrode is an anode electrode, at least one of the electron injection layer, the electron transport layer, or the hole blocking layer may be disposed between the exciton recombination layer and the nano antenna, and at least one of the hole injection layer, the hole transport layer, or the electron blocking layer is disposed between the exciton recombination layer and the second electrode. For ease of description, the following uses Case (1) for description. Case (2) is similar to Case (1), and details are not described below. In Case (1), if at least one of the hole injection layer, the hole transport layer, or the electron blocking layer is disposed between the exciton recombination layer and the nano antenna, a stacking sequence of the at least one of the hole injection layer, the hole transport layer, or the electron blocking layer may be random. This is not limited herein. Similarly, if at least one of the electron injection layer, the electron transport layer, or the hole blocking layer is disposed between the exciton recombination layer and the second electrode, a stacking sequence of the at least one of the electron injection layer, the electron transport layer, or the hole blocking layer may be random. This is not limited herein. For example, as shown in FIG. 7 (FIG. 7 is a diagram of another structure of a pixel unit according to an embodiment of this application), a nano antenna and a first electrode that are connected are disposed on a transparent substrate. An exciton recombination layer is disposed on the nano antenna and the first electrode. A second electrode is disposed on the exciton recombination layer. A hole injection layer is disposed between the nano antenna and the exciton recombination layer. An electron injection layer and an electron transport layer are disposed between the second electrode and the exciton recombination layer. It can be learned that, when the first electrode and the second electrode apply a specific voltage to the light-emitting layer, a hole and an electron move toward each other. To be specific, the hole moves from the first electrode to the second electrode (it is assumed that the first electrode is an anode electrode and the second electrode is a cathode electrode), and the electron moves from the second electrode to the first electrode. The hole and the electron recombine with each other at the exciton recombination layer to emit a light ray. This belongs to spontaneous emission. In this case, the light ray generated by the light-emitting layer (the exciton recombination layer in the light-emitting layer) is transmitted to the nano antenna, acts (couples) with the nano antenna connected to the first electrode, and then is transmitted by the nano antenna to the substrate.

In addition, a material of each layer included in the light-emitting layer may be shown in Table 1.

**Table 1**

| Light-emitting layer | Typical material |
|---|---|
| Hole injection layer | Hexaazatriphenylene hexacarbonitrile and polyester copper carbonate |
| Hole transport layer | Aromatic diamine and 2,2'-dimethyl-N,N'-di-1-naphthalene-N,N'-diphenyl[1,1'-biphenyl]-4,4'-diamine |
| Electron blocking layer | 9,9'-(1,3-phenyl)di-9H-clickazole and aluminum gallium nitrogen |
| Electron injection layer | Magnesium fluoride and aluminum oxide |
| Electron transport layer | Tris(8-hydroxyquinolinato)aluminum and 1,3,5-tris(1-phenyl-1H-benzimidazole-2-yl)benzene |
| Hole blocking layer | Lithium fluoride and 1,3,5-tris(1-phenyl-1H-benzimidazole-2-yl)benzene |
| Exciton recombination layer | Zinc phthalocyanine, doped tris(8-hydroxyquinolinato)aluminum, and 3-tert-butyl-9,10-di(naphthalene-2-yl)anthracene |

It should be understood that, in this embodiment, the materials shown in Table 1 are merely used as an example for description, and do not constitute a limitation on the material of each layer in the light-emitting layer.

In a possible implementation, to implement an effect of strong coupling between the exciton recombination layer and the nano antenna, a distance between the exciton recombination layer and the nano antenna may be set to be less than or equal to 20 nm. For example, the exciton recombination layer is in direct contact with the nano antenna. Alternatively, if at least one of the hole injection layer, the hole transport layer, or the electron blocking layer is disposed between the exciton recombination layer and the nano antenna, a total thickness of the at least one of the hole injection layer, the hole transport layer, or the electron blocking layer is less than or equal to 20 nm.

In a possible implementation, to prevent impact of the first electrode on resonance of the nano antenna and limit a light-emitting position of the entire pixel unit to an area in which the nano antenna is located, an insulating medium may be coated on a surface of the first electrode, so that the insulating medium covers only the first electrode. It can be learned that the first electrode and the light-emitting layer are separated by the insulating medium. The first electrode and the light-emitting layer are not in contact with each other, and only the nano antenna is in contact with the light-emitting layer. In this way, almost all the light rays emitted by the light emitting layer are emitted to the nano antenna. Still in the example shown in FIG. 7, the surface of the first electrode is coated with the insulating medium of a specific thickness. It can be learned the hole injection layer and the hole transport layer are between the nano antenna and the exciton recombination layer. In other words, the nano antenna is in contact with the light-emitting layer. The insulating medium is between the first electrode and the exciton recombination layer. In other words, the first electrode is not in contact with the light-emitting layer. Because there is no current in the insulating medium, there is no light ray in the insulating medium. Therefore, light rays generated by the light-emitting layer are centrally emitted to the nano antenna.

In a possible implementation, the first electrode and the second electrode are a pair of electrodes. Therefore, there are the following two cases: (1) The first electrode is an anode electrode, and the second electrode is a cathode electrode. (2) The first electrode is a cathode electrode, and the second electrode is an anode electrode. It should be noted that a difference between Case (1) and Case (2) lies in that materials and thicknesses of the layers in the light-emitting layer may be different. For example, in Case (2), a material whose electron mobility is lower than whose hole mobility is preferred for the exciton recombination layer. In Case (1), a material whose electron mobility is higher than whose hole mobility is preferred for the exciton recombination layer. In this way, a recombination region of the hole and the electron is close to the nano antenna. This facilitates efficient coupling for light emission.

The pixel unit provided in embodiments of this application includes the substrate, the nano antenna and the first electrode connected to the nano antenna that are formed on the substrate, the light-emitting layer formed on the nano antenna and the first electrode, and the second electrode formed on the light-emitting layer. In the pixel unit, driven by voltages provided by the first electrode and the second electrode, the light-emitting layer generates a plurality of light rays having different wavelengths, and emits the plurality of light rays to the nano antenna. Because the resonance band of the nano antenna includes the wavelength of the target light ray that may be emitted by the light-emitting layer, in the plurality of light rays generated by the light-emitting layer, at least one light ray whose wavelength is within the resonance band of the nano antenna, namely, the target light ray, can be enhanced by the nano antenna and transmitted to the substrate, so that the substrate transmits the target light ray to the outside of the pixel unit. The rest light rays whose wavelengths are outside the resonance band of the nano antenna are suppressed by the nano antenna, and are difficult to be transmitted to the substrate. In this way, the pixel unit can successfully emit the target light ray. The wavelength of the target light ray is selected. In other words, a color of the target light ray is selected. Therefore, the pixel unit can emit a light ray of a specific color. It can be learned that, in a display constructed by a plurality of pixel units provided in embodiments of this application, each pixel unit may select, by using a nano antenna of the pixel unit, a light ray having a specific wavelength (a color) to be emitted. In this way, light-emitting layers of the plurality of pixel units may be made of a same material (in other words, light rays emitted by the light-emitting layers of the plurality of pixel units are the same). In other words, the light-emitting layers of the plurality of pixel units may be integrally formed. Therefore, a sidewall of each pixel unit is not damaged. This can effectively improve light-emitting efficiency of all the pixel units.

Further, in the display constructed by the plurality of pixel units provided in embodiments of this application, the light-emitting layers of the plurality of pixel units may be made of a same material. Therefore, a same drive voltage may be applied to the light-emitting layers of the plurality of pixel units. It can be learned that, because the light-emitting layers are made of the same material and voltages required by the material are the same, complexity of a manufacturing process of the display can be reduced, thereby effectively reducing manufacturing costs.

Further, in embodiments of this application, even if the spontaneous emission linewidth of the pixel unit is usually large, that is, the band of the light ray that may be emitted by the pixel unit (the light-emitting layer of the pixel unit) is wide, because a range of the resonance band of the nano antenna may be set to be narrow (for example, the second-order resonance band of the nano antenna is used), the nano antenna may accurately excite the target light ray whose wavelength falls within the resonance band. This improves color purity of a light ray finally emitted by the pixel unit, thereby improving user experience.

Further, in the pixel unit provided in embodiments of this application, the nano antenna may excite, from the plurality of light rays generated by the light-emitting layer, the light ray that has a specific wavelength and a specific polarization direction (or an emission direction). Therefore, the display constructed based on the pixel unit provided in embodiments of this application does not need an additional polarization filter (or a direction filter). Consequently, intensity of the light ray emitted by the pixel unit is not weakened, and light-emitting efficiency of the pixel unit can be maintained.

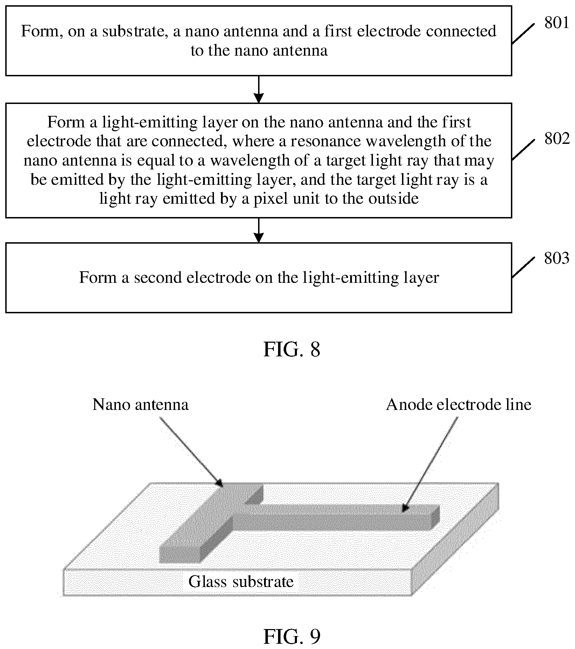

The foregoing describes in detail the pixel unit provided in embodiments of this application. The following describes a pixel unit manufacturing method according to an embodiment of this application. FIG. 8 is a schematic flowchart of the pixel unit manufacturing method according to an embodiment of this application. As shown in FIG. 8, the method includes the following steps.

801: Form, on a substrate, a nano antenna and a first electrode connected to the nano antenna.

In this embodiment, the nano antenna and the first electrode connected to the nano antenna may be manufactured on a (transparent) substrate. For example, as shown in FIG. 9 (FIG. 9 is a diagram of a manufacturing procedure of a pixel unit according to an embodiment of this application), a glass substrate is first coated with an anti-corrosion agent; then photoetching is performed; and then continuous vacuum thermal evaporation is performed. The nano antenna and the anode electrode line connected to the nano antenna are manufactured on the substrate in a specified length and shape.

In a possible implementation, both the first electrode and the nano antenna are of bar-shaped structures, and one end of the first electrode is connected to a middle part of the nano antenna.

In a possible implementation, the first electrode and the nano antenna are disposed at a same layer.

802: Form a light-emitting layer on the nano antenna and the first electrode that are connected, where a resonance wavelength of the nano antenna is equal to a wavelength of a target light ray that may be emitted by the light-emitting layer, and the target light ray is a light ray emitted by the pixel unit to the outside.

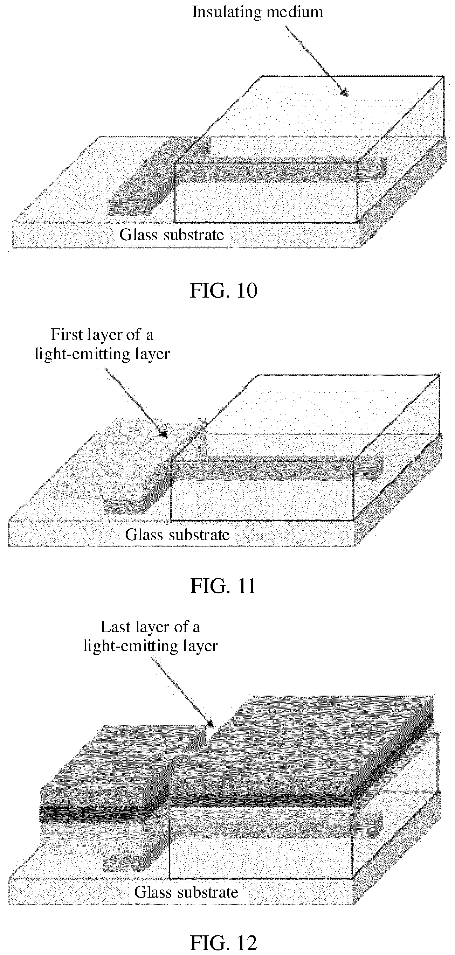

Then, the light-emitting layer may be formed on the nano antenna and the first electrode that are connected. Specifically, the light-emitting layer may be formed in the following manner:
(1) Form an insulating medium on the first electrode, where the insulating medium covers only the first electrode. For example, as shown in FIG. 10 (FIG. 10 is a diagram of another manufacturing procedure of a pixel unit according to an embodiment of this application, and FIG. 10 is obtained through drawing based on FIG. 9), an insulating medium layer covering the anode electrode line is manufactured by performing photoetching, to shield the electrode line, weaken impact of the electrode line on the nano antenna, and limit a light-emitting position of the pixel unit to an area near the nano antenna, because only the nano antenna is in direct contact with the light-emitting layer.
(2) Form an exciton recombination layer on the nano antenna and the first electrode that are connected, form at least one of a hole injection layer, a hole transport layer, or an electron blocking layer between the exciton recombination layer and the nano antenna, and form at least one of an electron injection layer, an electron transport layer, or a hole blocking layer between the exciton recombination layer and the second electrode. For example, as shown in FIG. 11 and FIG. 12 (FIG. 11 is a diagram of another manufacturing procedure of a pixel unit according to an embodiment of this application; FIG. 12 is a diagram of another manufacturing procedure of a pixel unit according to an embodiment of this application; FIG. 11 is obtained through drawing based on FIG. 10; and FIG. 12 is obtained through drawing based on FIG. 11), a first layer of the light-emitting layer is manufactured through vacuum thermal deposition (or solution deposition) and covers the nano antenna. Certainly, if the light-emitting layer includes a plurality of layers, layers other than the first layer may be manufactured through vacuum thermal deposition and sequentially cover a manufactured layer. It should be noted that some layers (for example, a second layer, a third layer, and a fourth layer of the light-emitting layer) in the light-emitting layer may also cover the insulating medium layer.

In a possible implementation, a second-order resonance band of the nano antenna includes the wavelength of the target light ray that may be emitted by the light-emitting layer.

In a possible implementation, a polarization direction of the nano antenna during resonance is the same as a polarization direction of the target light ray.

In a possible implementation, a direction in which the nano antenna emits a light ray during resonance is the same as an emission direction of the target light ray obtained after the target light ray passes through the nano antenna.

In a possible implementation, a distance between the exciton recombination layer and the nano antenna is less than or equal to 20 nm.

It should be understood that, in this embodiment, forming the insulating medium on the first electrode is merely used as an example for description. During actual application, the insulating medium may not be formed on the first electrode.

It should be further understood that, in this embodiment, at least one of a hole injection layer, a hole transport layer, or an electron blocking layer is formed between the exciton recombination layer and the nano antenna, and at least one of an electron injection layer, an electron transport layer, or a hole blocking layer is formed between the exciton recombination layer and the second electrode. This is merely for schematic description. During actual application, the following cases may alternatively exist: (1) The hole injection layer, the hole transport layer, and the electron blocking layer are not formed between the exciton recombination layer and the nano antenna, and the electron injection layer, the electron transport layer, and the hole blocking layer are not formed between the exciton recombination layer and the second electrode. (2) At least one of the hole injection layer, the hole transport layer, or the electron blocking layer is formed between the exciton recombination layer and the nano antenna, but the electron injection layer, the electron transport layer, and the hole blocking layer are not formed between the exciton recombination layer and the second electrode. (3) The hole injection layer, the hole transport layer, and the electron blocking layer are not formed between the exciton recombination layer and the nano antenna, but at least one of the electron injection layer, the electron transport layer, the hole blocking layer, or the like is formed between the exciton recombination layer and the second electrode.

It should be further understood that the foregoing merely uses an example in which the first electrode is an anode electrode and the second electrode is a cathode electrode for description. During actual application, the first electrode may alternatively be a cathode electrode, and the second electrode may alternatively be an anode electrode. In this case, after the exciton recombination layer is formed on the nano antenna and the first electrode that are connected, at least one of the electron injection layer, the electron transport layer, or the hole blocking layer may be formed between the exciton recombination layer and the nano antenna, and at least one of the hole injection layer, the hole transport layer, or the electron blocking layer is formed between the exciton recombination layer and the second electrode.

It should be further understood that, in the foregoing example, the at least one of the electron injection layer, the electron transport layer, or the hole blocking layer is formed between the exciton recombination layer and the nano antenna, and the at least one of the hole injection layer, the hole transport layer, or the electron blocking layer is formed between the exciton recombination layer and the second electrode. This is merely for schematic description. During actual application, the following cases may alternatively exist: (1) The electron injection layer, the electron transport layer, and the hole blocking layer are not formed between the exciton recombination layer and the nano antenna, and the hole injection layer, the hole transport layer, and the electron blocking layer are not formed between the exciton recombination layer and the second electrode. (2) At least one of the electron injection layer, the electron transport layer, or the hole blocking layer is formed between the exciton recombination layer and the nano antenna, but the hole injection layer, the hole transport layer, and the electron blocking layer are not formed between the exciton recombination layer and the second electrode. (3) The electron injection layer, the electron transport layer, and the hole blocking layer are not formed between the exciton recombination layer and the nano antenna, but at least one of the hole injection layer, the hole transport layer, or the electron blocking layer is formed between the exciton recombination layer and the second electrode.

803: Form a second electrode on the light-emitting layer.

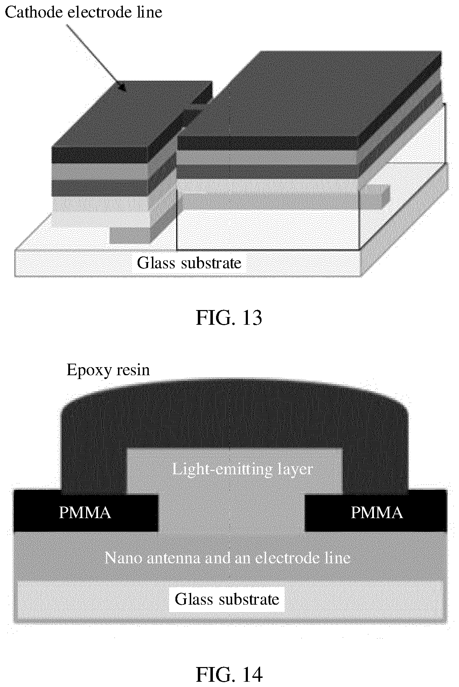

Finally, the second electrode may be formed on the light-emitting layer, to obtain the entire pixel unit. For example, as shown in FIG. 13 and FIG. 14 (FIG. 13 is a diagram of another manufacturing procedure of a pixel unit according to an embodiment of this application; FIG. 14 is a diagram of another manufacturing procedure of a pixel unit according to an embodiment of this application; FIG. 13 is obtained through drawing based on FIG. 12; and FIG. 14 is obtained by drawing based on FIG. 13), a cathode electrode line may be manufactured on a last layer of the light-emitting layer through vacuum thermal deposition. Before the cathode electrode line is manufactured, calcium or lithium fluoride may be deposited a nitrogen glove box system, to improve light-emitting performance. After the cathode electrode line is manufactured, the entire pixel unit may be packaged. To be specific, a top surface of the pixel unit is wrapped with epoxy resin in a nitrogen environment, to prevent water and oxygen from penetrating into the pixel unit. In addition, a polymethyl methacrylate (polymethyl methacrylate, PMMA) mask may be used to cover a side surface.

The pixel unit manufactured according to embodiments of this application includes the substrate, the nano antenna and the first electrode connected to the nano antenna that are formed on the substrate, the light-emitting layer formed on the nano antenna and the first electrode, and the second electrode formed on the light-emitting layer. In the pixel unit, driven by voltages provided by the first electrode and the second electrode, the light-emitting layer generates a plurality of light rays having different wavelengths, and emits the plurality of light rays to the nano antenna. Because the resonance band of the nano antenna includes the wavelength of the target light ray that may be emitted by the light-emitting layer, in the plurality of light rays generated by the light-emitting layer, at least one light ray whose wavelength is within the resonance band of the nano antenna, namely, the target light ray, can be enhanced by the nano antenna and transmitted to the substrate, so that the substrate transmits the target light ray to the outside of the pixel unit. The rest light rays whose wavelengths are outside the resonance band of the nano antenna are suppressed by the nano antenna, and are difficult to be transmitted to the substrate. In this way, the pixel unit can successfully emit the target light ray. The wavelength of the target light ray is selected. In other words, a color of the target light ray is selected. Therefore, the pixel unit can emit a light ray of a specific color. It can be learned that, in a display constructed by a plurality of pixel units provided in embodiments of this application, each pixel unit may select, by using a nano antenna of the pixel unit, a light ray having a specific wavelength (a color) to be emitted. In this way, light-emitting layers of the plurality of pixel units may be made of a same material. In other words, the light-emitting layers of the plurality of pixel units may be integrally formed. Therefore, a sidewall of each pixel unit is not damaged. This can effectively improve light-emitting efficiency of all the pixel units.

Embodiments of this application further relate to a pixel array. The pixel array includes the plurality of pixel units shown in FIG. 1, and the plurality of pixel units may be arranged in a specific sequence to form the array. It should be noted that light-emitting layers of the plurality of pixel units may be manufactured by using a same material, and therefore may be integrally formed.

Materials, shapes, and sizes of nano antennas of different pixel units in the plurality of pixel units may be the same or different. Therefore, resonance bands of the different pixel units may be the same or different. Similarly, polarization directions of the different pixel units during resonance may be the same or different, and light-emitting directions of the different pixel units during resonance may be the same or different.

In this way, the pixel array may simultaneously emit light rays with different wavelengths (colors), or may simultaneously emit light rays in different polarization directions (namely, different polarized light rays), or may simultaneously emit light rays in different emission directions.

For further understanding of the pixel array, the following further describes the pixel array with reference to a plurality of application examples.

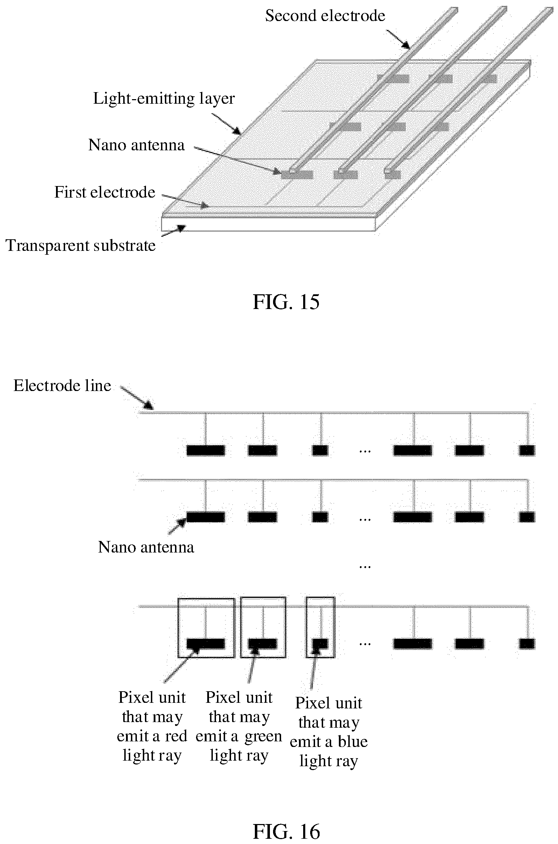

FIG. 15 is a diagram of an application example of the pixel array according to an embodiment of this application. As shown in FIG. 15, the pixel array includes three rows. Each row includes three pixel units. Nano antennas of the three pixel units are made of a same material and are all in a transverse bar shape. However, lengths of the three pixel units are different. The nano antenna of the pixel unit on the left is the longest; the nano antenna of the pixel unit in the middle is the second longest; and the nano antenna of the pixel unit on the left is the shortest. It should be noted that light-emitting layers of the nine pixel units may be integrally formed, and substrates of the nine pixel units may also be integrally formed. In addition, first electrodes and second electrodes of the nine pixel units may be disposed in a row-column staggering manner. Therefore, first electrodes in a row may be sequentially conducted for row selection, and then second electrodes of pixel units that need to emit light rays in the row are conducted, to control light emission of specific pixel units, namely, emission of light rays of a specific color.

FIG. 16 is a diagram of another application example of the pixel array according to an embodiment of this application. As shown in FIG. 16, the pixel array includes a plurality of rows. Each row includes a plurality of pixel units. The plurality of pixel units are sequentially a pixel unit that may emit a red light ray, a pixel unit that may emit a green light ray, a pixel unit that may emit a blue light ray, ..., a pixel unit that may emit a red light ray, a pixel unit that may emit a green light ray, and a pixel unit that may emit a blue light ray. A color of a light ray emitted by a pixel unit is determined by a length of a nano antenna of the pixel unit, and light-emitting layers of all the pixel units are manufactured by using a same material (that is, integrally formed). This can greatly facilitate manufacturing of the pixel array.

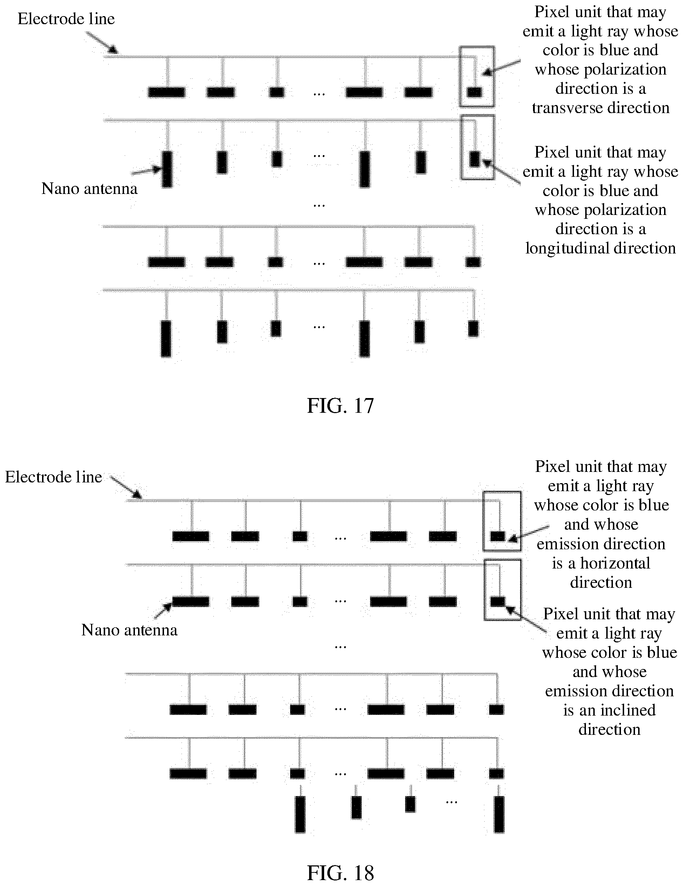

FIG. 17 is a diagram of another application example of the pixel array according to an embodiment of this application. As shown in FIG. 17, the pixel array includes a plurality of rows. A first row includes a plurality of pixel units. The plurality of pixel units are sequentially a pixel unit that may emit a light ray whose color is red and whose polarization direction is a transverse direction, a pixel unit that may emit a light ray whose color is green and whose polarization direction is the transverse direction, a pixel unit that may emit a light ray whose color is blue and whose polarization direction is the transverse direction, ..., and a pixel unit that may emit a light ray whose color is blue and whose polarization direction is the transverse direction. A second row includes a plurality of pixel units. The plurality of pixel units are sequentially a pixel unit that may emit a light ray whose color is red and whose polarization direction is a longitudinal direction, a pixel unit that may emit a light ray whose color is green and whose polarization direction is the longitudinal direction, a pixel unit that may emit a light ray whose color is blue and whose polarization direction is the longitudinal direction, ..., and a pixel unit that may emit a light ray whose color is blue and whose polarization direction is the longitudinal direction. By analogy, a last row includes a plurality of pixel units. The plurality of pixel units are sequentially a pixel unit that may emit a light ray whose color is red and whose polarization direction is a longitudinal direction, a pixel unit that may emit a light ray whose color is green and whose polarization direction is the longitudinal direction, a pixel unit that may emit a light ray whose color is blue and whose polarization direction is the longitudinal direction, ..., and a pixel unit that may emit a light ray whose color is blue and whose polarization direction is the longitudinal direction. A color of a light ray emitted by a pixel unit is determined by a length of a nano antenna of the pixel unit, and a polarization direction of the light ray emitted by the pixel unit is determined by a shape of the nano antenna of the pixel unit. Therefore, the pixel array may implement light emission of a plurality of types of polarization by using a polarization direction of the nano antenna during resonance, and no additional polarization filter is required. This can avoid a loss of light-emitting efficiency.

FIG. 18 is a diagram of another application example of the pixel array according to an embodiment of this application. As shown in FIG. 18, the pixel array includes a plurality of rows. A first row includes a plurality of pixel units. The plurality of pixel units are sequentially a pixel unit that may emit a light ray whose color is red and whose emission direction is a horizontal direction, a pixel unit that may emit a light ray whose color is green and whose emission direction is the horizontal direction, a pixel unit that may emit a light ray whose color is blue and whose emission direction is the horizontal direction, ..., and a pixel unit that may emit a light ray whose color is blue and whose emission direction is the horizontal direction. The second row includes a plurality of pixel units. The plurality of pixel units are sequentially a pixel unit that may emit a light ray whose color is red and whose emission direction is an inclined direction, a pixel unit that may emit a light ray whose color is green and whose emission direction is the inclined direction, a pixel unit that may emit a light ray whose color is blue and whose emission direction is the inclined direction, ..., and a pixel unit that may emit a light ray whose color is blue and whose emission direction is the inclined direction. By analogy, a last row includes a plurality of pixel units. The plurality of pixel units are sequentially a pixel unit that may emit a light ray whose color is red and whose emission direction is the inclined direction, a pixel unit that may emit a light ray whose color is green and whose emission direction is the inclined direction, a pixel unit that may emit a light ray whose color is blue and whose emission direction is the inclined direction, ..., and a pixel unit that may emit a light ray whose color is blue and whose emission direction is the inclined direction. A color of a light ray emitted by the pixel unit is determined by a length of a nano antenna of the pixel unit, and a light-emitting direction of the pixel unit is determined by a shape of the nano antenna of the pixel unit. Therefore, the pixel array may implement light emission of a plurality of types of light emitting by using a light emission direction of the nano antenna during resonance, and no additional light-emitting filter is required. This can avoid a loss of light-emitting efficiency.

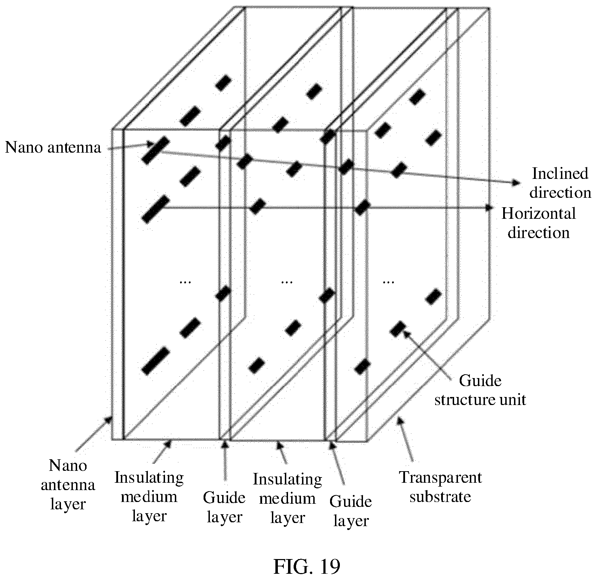

FIG. 19 is a diagram of another application example of the pixel array according to an embodiment of this application. As shown in FIG. 19, in the pixel array, an insulating medium layer and a guide layer that are arranged in a staggered manner may be disposed between a nano antenna layer and the substrate, so that a component (a unit) outside the nano antenna is used to set a light-emitting direction of the pixel unit. A guide structure unit (which may be made of a metal material or another conductive material) is deployed in the guide layer. In this case, after passing through the insulating medium layer, light rays acting on the nano antenna are concentrated on the guide structure unit in the guide layer, and are emitted in a direction (for example, the horizontal direction or the inclined direction in FIG. 19) under guidance of the guide structure unit.

Embodiments of this application further relate to a display. The display may include a driver chip and the pixel array described in any one of FIG. 14 to FIG. 19. The driver chip is configured to provide a drive voltage for the pixel array.

Embodiments of this application further relate to an electronic device. The electronic device includes a processor, a memory, and the foregoing display.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A pixel unit, wherein the pixel unit comprises:
a substrate;
a nano antenna and a first electrode that are formed on the substrate, wherein the nano antenna is connected to the first electrode;
a light-emitting layer formed on the nano antenna and the first electrode, wherein a resonance band of the nano antenna comprises a wavelength of a target light ray emitted by the light-emitting layer, and the target light ray is a light ray emitted by the pixel unit to an outside; and
a second electrode formed on the light-emitting layer.

2. The pixel unit according to claim 1, wherein both the first electrode and the nano antenna are of bar-shaped structures, and one end of the first electrode is connected to a middle part of the nano antenna.

3. The pixel unit according to claim 1 or 2, wherein the first electrode and the nano antenna are disposed at a same layer.

4. The pixel unit according to any one of claims 1 to 3, wherein a second-order resonance band of the nano antenna comprises the wavelength of the target light ray emitted by the light-emitting layer.

5. The pixel unit according to any one of claims 1 to 4, wherein a polarization direction of the nano antenna during resonance is the same as a polarization direction of the target light ray.

6. The pixel unit according to any one of claims 1 to 5, wherein a direction in which the nano antenna emits a light ray during resonance is the same as an emission direction of the target light ray obtained after the target light ray passes through the nano antenna.

7. The pixel unit according to any one of claims 1 to 6, wherein the pixel unit further comprises an insulating medium, and the insulating medium covers only the first electrode.

8. The pixel unit according to any one of claims 1 to 7, wherein the light-emitting layer comprises an exciton recombination layer.

9. The pixel unit according to claim 8, wherein the light-emitting layer further comprises at least one of the following: a hole injection layer, a hole transport layer, an electron blocking layer, an electron injection layer, an electron transport layer, or a hole blocking layer; and
at least one of the hole injection layer, the hole transport layer, or the electron blocking layer is formed between the exciton recombination layer and the nano antenna, and at least one of the electron injection layer, the electron transport layer, or the hole blocking layer is formed between the exciton recombination layer and the second electrode; or
at least one of the electron injection layer, the electron transport layer, or the hole blocking layer is formed between the exciton recombination layer and the nano antenna, and at least one of the hole injection layer, the hole transport layer, or the electron blocking layer is formed between the exciton recombination layer and the second electrode.

10. The pixel unit according to claim 9, wherein a distance between the exciton recombination layer and the nano antenna is less than or equal to 20 nm.

11. The pixel unit according to any one of claims 1 to 10, wherein the first electrode is an anode electrode and the second electrode is a cathode electrode, or the first electrode is a cathode electrode and the second electrode is an anode electrode.

12. A pixel unit manufacturing method, wherein the method comprises:
forming, on a substrate, a nano antenna and a first electrode connected to the nano antenna;
forming a light-emitting layer on the nano antenna and the first electrode that are connected, wherein a resonance wavelength of the nano antenna is equal to a wavelength of a target light ray emitted by the light-emitting layer, and the target light ray is a light ray emitted by the pixel unit to an outside; and
forming a second electrode on the light-emitting layer.

13. The method according to claim 12, wherein both the first electrode and the nano antenna are of bar-shaped structures, and one end of the first electrode is connected to a middle part of the nano antenna.

14. The pixel unit according to claim 12 or 13, wherein the first electrode and the nano antenna are disposed at a same layer.

15. The method according to any one of claims 12 to 14, wherein a second-order resonance band of the nano antenna comprises the wavelength of the target light ray emitted by the light-emitting layer.

16. The method according to any one of claims 12 to 15, wherein a polarization direction of the nano antenna during resonance is the same as a polarization direction of the target light ray.

17. The method according to any one of claims 12 to 16, wherein a direction in which the nano antenna emits a light ray during resonance is the same as an emission direction of the target light ray obtained after the target light ray passes through the nano antenna.

18. The method according to any one of claims 12 to 17, wherein the method further comprises:
forming an insulating medium on the first electrode, wherein the insulating medium covers only the first electrode.

19. The method according to any one of claims 12 to 18, wherein the forming a light-emitting layer on the nano antenna and the first electrode that are connected comprises:
forming an exciton recombination layer on the nano antenna and the first electrode that are connected.

20. The method according to claim 19, wherein the forming a light-emitting layer on the nano antenna and the first electrode that are connected further comprises:
forming at least one of the hole injection layer, the hole transport layer, or the electron blocking layer between the exciton recombination layer and the nano antenna, and forming at least one of the electron injection layer, the electron transport layer, or the hole blocking layer between the exciton recombination layer and the second electrode; or
forming at least one of the electron injection layer, the electron transport layer, or the hole blocking layer between the exciton recombination layer and the nano antenna, and forming at least one of the hole injection layer, the hole transport layer, or the electron blocking layer between the exciton recombination layer and the second electrode.

21. The method according to claim 20, wherein a distance between the exciton recombination layer and the nano antenna is less than or equal to 20 nm.

22. The method according to any one of claims 12 to 21, wherein the first electrode is an anode electrode and the second electrode is a cathode electrode, or the first electrode is a cathode electrode and the second electrode is an anode electrode.

23. A pixel array, wherein the pixel array comprises a plurality of pixel units according to any one of claims 1 to 11, and light rays emitted by light-emitting layers of the plurality of pixel units are the same.

24. The pixel array according to claim 23, wherein the light-emitting layers of the plurality of pixel units are integrally formed.

25. A display, wherein the display comprises a driver chip and the pixel array according to claim 23 or 24, and the driver chip is configured to provide a drive voltage for the pixel array.

26. An electronic device, wherein the electronic device comprises a processor, a memory, and the display according to claim 25.
